# EUROPEAN PATENT APPLICATION

(11) **EP 3 808 489 A1**
(43) Date of publication of application: **21.04.2021**
(21) Application number: 20193537.6
(22) Date of filing: 31.08.2020
(51) Int. Cl.: B23K 9/10

(54) **SYSTEM AND METHOD TO SWITCH BETWEEN ELECTRICALLY ISOLATED WELDING OUTPUT STUDS BY SENSING AN ELECTRODE TOUCH**

(30) Priority: 11.09.2019 US 201962898599 P; 17.02.2020 US 202016792372
(71) Applicant: Lincoln Global, Inc., Santa Fe Springs, CA 90670 (US)
(72) Inventor: MEHLMAN, Alexander C., Strongsville, OH Ohio 44149 (US)
(74) Representative: Grosse Schumacher Knauer von Hirschhausen

(57) **Abstract**

Embodiments of welding machines (100) and methods for switching between electrically isolated welding output studs (120). One embodiment of a welding machine (100) includes multiple welding output studs (120), a work stud (100), a contactor circuit (220), touch sense circuitry (230), and a contactor controller (210, 500). The contactor controller (210, 500) is configured to determine that electrical contact has occurred between a first welding output stud of the multiple welding output studs (120) and the work stud (160) via the touch sense circuitry (230). The contactor controller (210, 500) is also configured to deactivate welding output power to other welding output studs (120) of the multiple welding output studs (120) via the contactor circuit (220) based on determining that the electrical contact has occurred. The contactor controller (210, 500) is further configured to activate welding output power to the first welding output stud via the contactor circuit (220) after deactivating the other welding output studs based on determining that the electrical contact has occurred.

## Description

The invention is related to a welding machine according to claim 1 and to a method of switching between welding output studs of a welding machine according to claim 11. The present application claims priority to U.S. Provisional Patent Application 62/898,599, filed September 11, 2019, and also claims priority to U.S. Non-Provisional Patent Application 16/792,372, filed February 17, 2020, both of which are incorporated herein by reference in their entirety.

### FIELD OF THE INVENTION

Embodiments of the present invention relate to welding machines and methods, and more specifically to welding machines and methods providing the ability to switch between electrically isolated welding output studs of a welding machine by sensing an electrode touch.

### TECHNICAL BACKGROUND

Currently, some welding machines provide multiple electrically isolated output studs to support different welding processes. To change which output stud is actually electrically active at a given time, a user has to manually make a selection (e.g., press a button) on a user interface of the welding machine.

### DESCRIPTION

In order to improve handling during welding operation, a welding machine according to claim 1 is described and a method of switching between welding output studs of a welding machine according to claim 11. Preferred embodiments are subject of the subclaims. Embodiments of the present invention are related to welding machines having an electrically isolated touch sense circuit connected between each welding output stud and a work stud. When a user touches an electrode connected to a welding output stud to a workpiece connected to the work stud, an output level of a corresponding touch sense circuit will change to indicate to a contactor controller of the welding machine to make that welding output stud electrically active and to ensure that the other welding output studs are electrically inactive.

Embodiments of welding machines and methods for switching between welding output studs are disclosed. One embodiment of a welding machine includes electrically isolated welding output studs, a work stud, a contactor circuit including electrical contactors, and a contactor controller including a microprocessor, drives to control contactor coils, and touch sense circuitry. The contactor controller determines when electrical contact has occurred between a first welding output stud and the work stud via a first touch sense circuit of the touch sense circuitry. The contactor controller deactivates welding output power to the other welding output studs via the contactor circuit based on determining that the electrical contact has occurred. The contactor controller activates welding output power to the first welding output stud via the contactor circuit after deactivating the other welding output studs based on determining that the electrical contact has occurred. The term "contactor circuit" is used broadly herein and may include a device with actual electrical contactors or may include, for example, solid state devices.

In one embodiment, a welding machine includes multiple electrically isolated welding output studs, a work stud, a contactor circuit, touch sense circuitry, and a contactor controller. The contactor controller is configured to determine that electrical contact has occurred between a first welding output stud of the multiple electrically isolated welding output studs and the work stud via the touch sense circuitry. The contactor controller is also configured to deactivate welding output power to other welding output studs of the multiple electrically isolated welding output studs via the contactor circuit based on determining that the electrical contact has occurred. The contactor controller is further configured to activate welding output power to the first welding output stud via the contactor circuit after deactivating the other welding output studs based on determining that the electrical contact has occurred. In one embodiment, the contactor circuit includes multiple electrical contactors. In another embodiment, the contactor circuit includes multiple solid state devices. In one embodiment, the touch sense circuitry is part of the contactor controller. In another embodiment, the touch sense circuitry is external to the contactor controller and operatively interfaces to the contactor controller. In one embodiment, the welding machine also includes a shielded metal arc welding (SMAW) tool configured to operatively connect to a SMAW welding output stud of the multiple welding output studs. In one embodiment, the welding machine also includes a gas tungsten arc welding (GTAW) tool configured to operatively connect to a GTAW welding output stud of the multiple welding output studs. In one embodiment, the welding machine also includes a gas metal arc welding (GMAW) tool and a wire feeder configured to operatively connect to a GMAW welding output stud of the multiple electrically isolated welding output studs. In one embodiment, the contactor controller is configured to provide coil drive signals to control electrical contactors of the contactor circuit. In one embodiment, the contactor controller is configured to provide input activation signals to control solid state devices of the contactor circuit. In one embodiment, the touch sense circuitry is configured to provide a voltage signal to the work stud. In one embodiment, the welding machine also includes sense signal circuit paths between the welding output studs and the touch sense circuitry. In one embodiment, the touch sense circuitry includes voltage sense circuits. In one embodiment, the touch sense circuitry includes current sense circuits.

One embodiment includes a method of switching between welding output studs of a welding machine. The method includes determining a first electrical contact between a first welding output stud of a welding machine and a work stud of the welding machine via a first touch sense circuit of the welding machine. The method also includes, in response to determining the first electrical contact, deactivating a second welding output power to a second welding output stud of the welding machine via a controller of the welding machine controlling a contactor circuit of the welding machine, and activating a first welding output power to the first welding output stud via the controller again controlling the contactor circuit after deactivating the second welding output power to the second welding output stud. In one embodiment, the method further includes determining a second electrical contact between the second welding output stud and the work stud via a second touch sense circuit of the welding machine. The method also includes, in response to determining the second electrical contact, deactivating the first welding output power to the first welding output stud via the controller again controlling the contactor circuit, and activating the second welding output power to the second welding output stud via the controller again controlling the contactor circuit after deactivating the first welding output power to the first welding output stud. In one embodiment, the controller generates coil drive signals to control electrical contactors of the contactor circuit. In one embodiment, the controller generates activation input signals to control solid state devices of the contactor circuit. In one embodiment, the first touch sense circuit senses a voltage or a current when the first electrical contact occurs between the first welding output stud and the work stud. In one embodiment, the second touch sense circuit senses a voltage or a current when the second electrical contact occurs between the second welding output stud and the work stud. In accordance with other embodiments, the number of studs is not limited to two, but can be any number of studs for different applications. For example, a specific welding studs could be provided for arc gouging, SMAW, and GTAW.

Numerous aspects of the general inventive concepts will become readily apparent from the following detailed description of exemplary embodiments and from the accompanying drawings.

### BRIEF DESCRIPTION OF THE DRAWINGS

The accompanying drawings, which are incorporated in and constitute a part of the specification, illustrate various embodiments of the disclosure. It will be appreciated that the illustrated element boundaries (e.g., boxes, groups of boxes, or other shapes) in the figures represent one embodiment of boundaries. In some embodiments, one element may be designed as multiple elements or multiple elements may be designed as one element. In some embodiments, an element shown as an internal component of another element may be implemented as an external component and vice versa. Furthermore, elements may not be drawn to scale.
FIG. 1 illustrates a schematic block diagram of one embodiment of a welding machine having multiple electrically isolated welding output studs;
FIG. 2 illustrates a schematic diagram of one embodiment showing the interconnectivity between a contactor controller, a set of electrical contactors, touch sense circuitry having a set of touch sense circuits, and a set of welding output studs of the welding machine of FIG. 1;
FIG. 3 illustrates a flow chart of one embodiment of a method to switch between the welding output studs of the welding machine of FIG. 1 based on the interconnectivity shown in FIG. 2;
FIG. 4 illustrates a schematic block diagram of one embodiment of the touch sense circuitry of FIG. 2; and
FIG. 5 illustrates one embodiment of an example controller (e.g., the contactor controller of FIG. 2 used in the welding machine of FIG. 1).

### DETAILED DESCRIPTION

Embodiments of the present invention are concerned with providing touch-sensitive switching between electrically isolated welding output studs on a welding machine. In one embodiment, a contactor controller of a welding machine determines, via a touch sense circuit, that electrical contact has occurred between a first welding output stud of a welding machine and a work stud of the welding machine (e.g., when a user touches a welding electrode connected to the first welding output stud to a workpiece connected to the work stud). The contactor controller deactivates welding output power to any other welding output studs of the welding machine via a contactor circuit based on determining that electrical contact has occurred between the first welding output stud and the work stud. The contactor controller activates welding output power to the first welding output stud via the contactor circuit after deactivating power to the other welding output studs based on determining that electrical contact has occurred between the first welding output stud and the work stud.

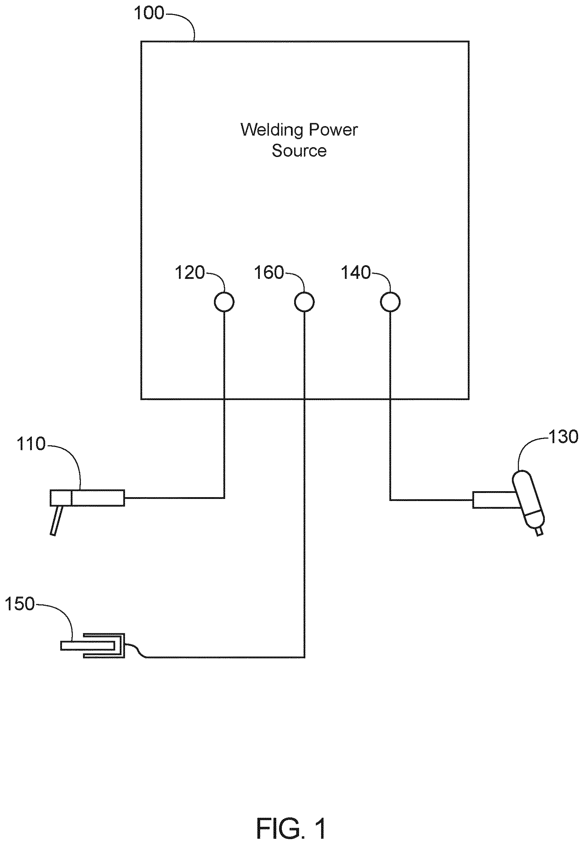

The examples and figures herein are illustrative only and are not meant to limit the subject invention, which is measured by the scope and spirit of the claims. FIG. 1 illustrates a schematic block diagram of one embodiment of a welding machine 100 (including a welding power source having welding power electronics) having multiple electrically isolated welding output studs, which provide the ability to connect different types of welding tool setups (e.g., SMAW, GTAW, GMAW) at the same time. Furthermore, touch sense circuitry allows the operator to switch between welding processes more easily since the operator does not have to go to the user interface controls of the welding machine. Such setups and capabilities may be very useful in, for example, pipe fabrication.

FIG. 1 shows a shielded metal arc welding (SMAW) tool 110 connected to a first welding output stud 120 of the welding machine 100, a gas tungsten arc welding (GTAW) tool 130 connected to a second welding output stud 140 of the welding machine 100, and a workpiece 150 connected to a work stud 160 of the welding machine 100. In this manner, an operator of the welding machine 100 can perform SMAW welding on the workpiece, and then switch to performing GTAW welding on the workpiece, or vice versa. In accordance with other embodiments, other types of arc welding tools may be connected to the welding studs of the welding machine 100 and switched between in a similar manner, and/or additional welding studs may be provided as well in a similar manner. However, in accordance with one embodiment, a GMAW stud is not switched in this manner. Instead, there is a trigger on the GMAW tool (e.g., a GMAW welding gun connected to the GMAW stud) which is used to indicate that the operator wants to activate the GMAW tool.

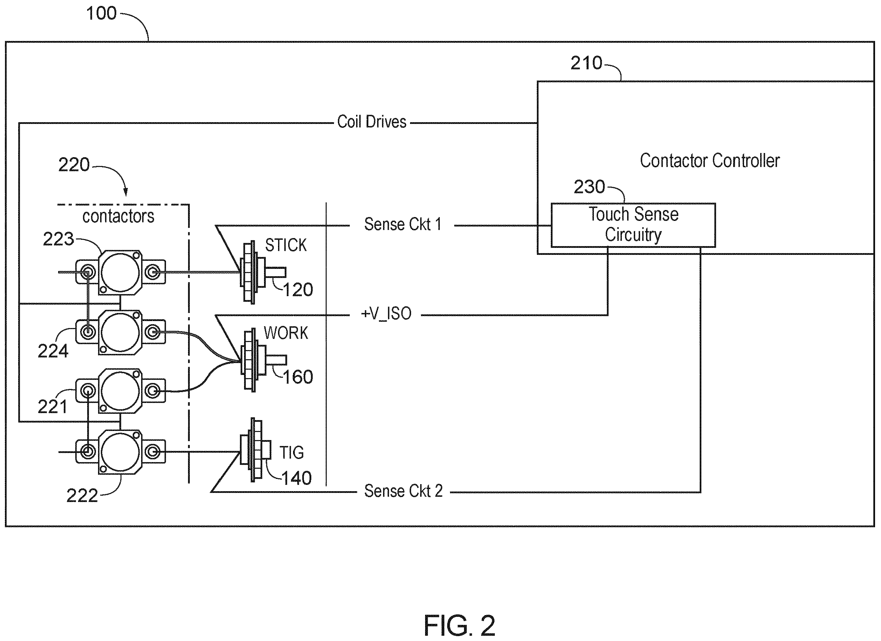

FIG. 2 illustrates a schematic diagram of one embodiment showing the interconnectivity between a contactor controller 210, a contactor circuit 220, a touch sense circuitry 230 (e.g., mounted on a touch sense circuit board) having a set of touch sense circuits, and the welding output studs 120, 140, and 160 of the welding machine 100 of FIG. 1. As seen in FIG. 2, the touch sense circuitry 230 is part of the contactor controller 210. However, in other embodiments, the touch sense circuitry 230 could be external to the contactor controller 210, or even external to the welding machine 100, and operatively interface to the contactor controller 210.

In one embodiment, the contactor controller 210 provides coil drive signals to the contactor circuit 220 to activate and deactivate the electrical contactors of the contactor circuit 220. For example, when operating in the SMAW mode, the contactor controller 210 activates welding output power to the welding output stud 120 by deactivating the electrical contactor 224 and the electrical contactor 222 and activating the electrical contactor 223 and the electrical contactor 221. Similarly, when operating in the GTAW mode, the contactor controller 210 activates welding output power to the welding output stud 140 by deactivating the electrical contactor 223 and the electrical contactor 221 and activating the electrical contactor 224 and the electrical contactor 222. In another embodiment, the contactor circuit may not include actual electrical contactors but may include, for example, solid state devices that functionally operate in a similar manner as described herein. As a result, instead of coil drive signals, the contactor controller 210 provides activation input signals to the contactor circuit to activate and deactivate the solid state devices of the contactor circuit. In accordance with one embodiment, the electrical contactors 223 and 222 are electrically connected to the electrical output of the welding power source of the welding machine 100.

A voltage signal V_ISO (e.g., a voltage level) is provided by the touch sense circuitry 230 to the work stud 160. A first circuit path (Sense Ckt 1) for a first sense signal is provided from the welding output stud 120 to the touch sense circuitry 230. Similarly, a second circuit path (Sense Ckt 2) for a second sense signal is provided from the welding output stud 140 to the touch sense circuitry 230.

When the welding output stud 120 makes electrical contact with (e.g., is electrically shorted to) the work stud 160 (e.g., by touching an electrode of a welding tool connected to the welding output stud 120 to a workpiece connected to the work stud 160), an electrical return path is completed such that the voltage signal V_ISO is applied to the first circuit path (Sense Ckt 1) and detected by a first touch sense circuit of the touch sense circuitry 230 in the contactor controller 210. In response, the contactor controller 210 deactivates the electrical contactors 224 and 222 and activates the electrical contactors 223 and 221. In this manner welding output power is applied to welding output stud 120 and is not applied to welding output stud 140. An operator may then proceed to weld a workpiece connected to the work stud 160 using a welding tool connected to the welding output stud 120.

Similarly, when the welding output stud 140 makes electrical contact with (e.g., is electrically shorted to) the work stud 160 (e.g., by touching an electrode of a welding tool connected to the welding output stud 140 to a workpiece connected to the work stud 160), an electrical return path is completed such that the voltage signal V_ISO is applied to the second circuit path (Sense Ckt 2) and detected by a second touch sense circuit of the touch sense circuitry 230 in the contactor controller 210. In response, the contactor controller 210 deactivates the electrical contactors 223 and 221 and activates the electrical contactors 224 and 222. In this manner welding output power is applied to welding output stud 140 and is not applied to welding output stud 120. An operator may then proceed to weld a workpiece connected to the work stud 160 using a welding tool connected to the welding output stud 140.

In accordance with various embodiments of the present invention, the first touch sense circuit and the second touch sense circuit of the touch sense circuitry 230 may be voltage sense circuits or current sense circuits. Voltage sense circuits and current sense circuits are well known in the art and may include, for example, any of transistors, resistors, operational amplifiers, capacitors, diodes, integrated circuit chips, or various combinations thereof. Other various components may be possible as well, in accordance with other various embodiments. For example, a well-known integrated circuit chip known as the LM741 may be used as at least a part of a voltage sense circuit of the touch sense circuitry 230, in accordance with one embodiment. As another example, a microcontroller may be used, in accordance with one embodiment.

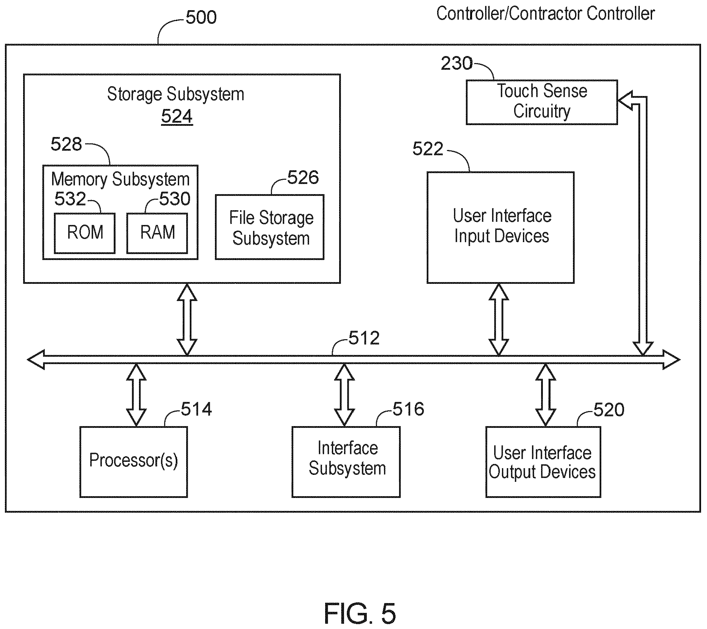

In one embodiment, the contactor controller 210 is a main controller of the welding machine 100 that performs many other (or possibly all) control functions of the welding machine 100, not just the touch-sensing functionality and control as described herein. For example, the contactor controller 210 may be a main controller that includes other components as well, in accordance with various embodiments (e.g., see the controller 500 of FIG. 5 herein).

In an alternative embodiment, a gas metal arc welding (GMAW) stud is also provided by the welding machine which does not have a touch sense circuit connected to it. Instead, a wire feeder connected to the GMAW stud contains electrical contactors (or solid state circuitry) which are "opened" upon sensing a touch from an SMAW or GTAW tool.

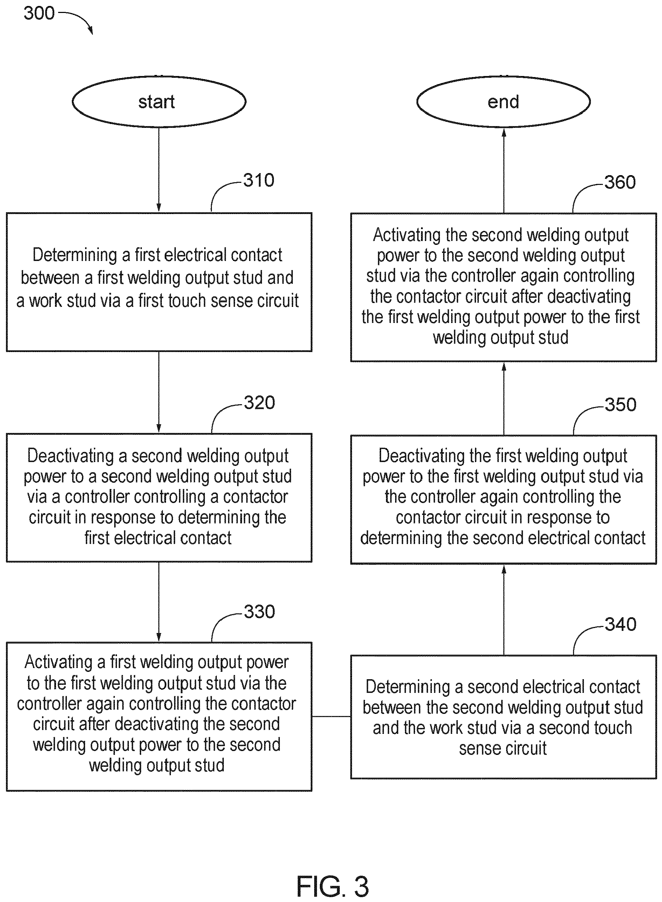

FIG. 3 illustrates a flow chart of one embodiment of a method 300 to switch between the welding output studs 120 and 140 of the welding machine 100 of FIG. 1 based on the interconnectivity shown in FIG. 2. Welding output stud 120 corresponds to a first welding process and welding output stud 140 corresponds to a second welding output process. Referring to FIGS. 1-3, at block 310 of the method 300, the controller 210 determines that a first electrical contact has occurred between the first welding output stud 120 of the welding machine 100 and the work stud 160 of the welding machine 100 via a first touch sense circuit of the touch sense circuitry 230. The first electrical contact can occur by an operator touching an electrode of the first welding tool 110 connected to the first welding output stud 120 to the workpiece 150 connected to the work stud 160. At block 320, the controller 210 deactivates a second welding output power to the second welding output stud 140 of the welding machine 100 via the contactor circuit 220 based on determining the occurrence of the first electrical contact. At block 330, the controller 210 activates a first welding output power to the first welding output stud 120 via the contactor circuit 220 after deactivating the second welding output power to the second welding output stud 140 based on determining the occurrence of the first electrical contact. There may or may not be a change in polarity between the first welding process and the second welding process. In the case of no change in polarity, only two contactors may be required.

At block 340 of the method 300, the controller 210 determines that a second electrical contact has occurred between the second welding output stud 140 of the welding machine 100 and the work stud 160 of the welding machine 100 via a second touch sense circuit of the touch sense circuitry 230. The second electrical contact can occur by an operator touching an electrode of the second welding tool 130 connected to the second welding output stud 140 to the workpiece 150 connected to the work stud 160. At block 350, the controller 210 deactivates the first welding output power to the first welding output stud 120 of the welding machine 100 via the contactor circuit 220 based on determining the occurrence of the second electrical contact. At block 360, the controller 210 activates the second welding output power to the second welding output stud 140 via the contactor circuit 220 after deactivating the first welding output power to the first welding output stud 120 based on determining the occurrence of the second electrical contact.

In this manner, an operator of the welding machine 100 can readily switch between two different welding tools connected to two different electrically isolated welding output studs of the welding machine simply by touching an electrode of a welding tool to be used next to a workpiece connected to a work stud of the welding machine, instead of having to go to the user interface controls of the welding machine. However, there is no practical limit of having only two studs. Additional studs can be provided, in accordance with other embodiments, which can be switched between in a similar manner. For example, three or four studs may be provided, each corresponding to a separate welding mode or process, which can be switched between.

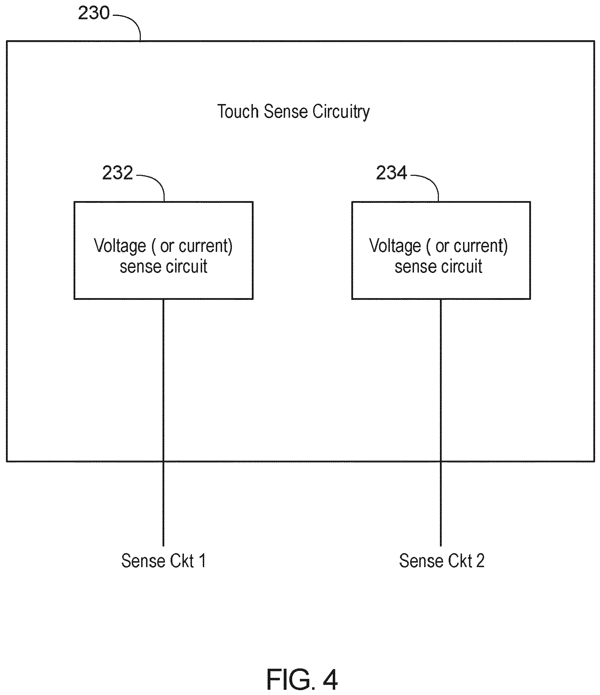

FIG. 4 illustrates a schematic block diagram of one embodiment of the touch sense circuitry 230 of FIG. 2. The touch sense circuitry 230 includes a first voltage (or current) sense circuit 232 and a second voltage (or current) sense circuit 234. Referring again to FIG. 2, the first voltage (or current) sense circuit 232 is operatively connected to the first welding output stud 120 via the Sense Ckt 1 circuit path. Similarly, the second voltage (or current) sense circuit 234 is operatively connected to the second welding output stud 140 via the Sense Ckt 2 circuit path. Furthermore, both sense circuits 232 and 234 operatively interface to the contactor controller 210. As stated previously herein, voltage sense circuits and current sense circuits are well known in the art and may include, for example, any of transistors, resistors, operational amplifiers, capacitors, diodes, integrated circuit chips, or various combinations thereof. Other various components may be possible as well, in accordance with other various embodiments. For example, a well-known integrated circuit chip known as the LM741 may be used as at least a part of a voltage sense circuit of the touch sense circuitry 230, in accordance with one embodiment.

FIG. 5 illustrates one embodiment of an example controller 500 (e.g., the contactor controller 210 of FIG. 2 used in the welding machine 100 of FIG. 1). The controller 500 includes the touch sense circuitry 230, as discussed previously herein. As stated previously herein, in one embodiment, the contactor controller 210 is a main controller of the welding machine 100 that performs many other (or possibly all) control functions of the welding machine 100, not just the touch-sensing functionality and control as described herein. For example, the controller may encompass all controls in the entire welding system and may not be limited to one specific PCB or assembly. The controller may be a combination of many items spread between, for example, a wire feeder, a power source, and accessories.

The controller 500 also includes at least one processor 514 (e.g., a microprocessor) which communicates with a number of peripheral devices via bus subsystem 512. These peripheral devices may include a storage subsystem 524, including, for example, a memory subsystem 528 and a file storage subsystem 526, user interface input devices 522, user interface output devices 520, and a network interface subsystem 516. The input and output devices allow user interaction with the controller 500. Interface subsystem 516 provides an interface to outside devices and networks and is coupled to corresponding interface devices in other computer or electronic systems such as, for example, conventional computers, digital signal processors, and/or other electrical and/or computing devices. For example, in one embodiment, interface subsystem 516 supports interfacing of the controller 500 to the contactor circuit 220 and the studs 120, 140, and 160 of the welding machine 100.

User interface input devices 522 may include a pushbutton, an encoder, a keyboard, pointing devices such as a mouse, trackball, touchpad, or graphics tablet, a scanner, a touchscreen incorporated into the display, audio input devices such as voice recognition systems, microphones, and/or other types of input devices. In general, use of the term "input device" is intended to include all possible types of devices and ways to input information into the controller 500 or onto a communication network.

User interface output devices 520 may include a display subsystem, a printer, a fax machine, or non-visual displays such as audio output devices. The display subsystem may include a cathode ray tube (CRT), a flat-panel device such as a liquid crystal display (LCD), a projection device, or some other mechanism for creating a visible image. The display subsystem may also provide non-visual display such as via audio output devices. In general, use of the term "output device" is intended to include all possible types of devices and ways to output information from the controller 500 to the user or to another machine or computer system.

Storage subsystem 524 stores programming and data constructs that provide or support some or all of the functionality described herein (e.g., as software modules). For example, the storage subsystem 524 may include various programmable welding mode constructs for controlling switching between the welding output studs (and associated welding modes) as discussed previously herein.

Software modules are generally executed by processor 514 alone or in combination with other processors. Memory 528 used in the storage subsystem can include a number of memories including a main random access memory (RAM) 530 for storage of instructions and data during program execution and a read only memory (ROM) 532 in which fixed instructions are stored. A file storage subsystem 526 can provide persistent storage for program and data files, and may include a hard disk drive, a floppy disk drive along with associated removable media, a CD-ROM drive, an optical drive, or removable media cartridges. The modules implementing the functionality of certain embodiments may be stored by file storage subsystem 526 in the storage subsystem 524, or in other machines accessible by the processor(s) 514.

Bus subsystem 512 provides a mechanism for letting the various components and subsystems of the controller 500 communicate with each other as intended. Although bus subsystem 512 is shown schematically as a single bus, alternative embodiments of the bus subsystem may use multiple buses.

The controller 500 can be configured as any of various types including a microprocessor and other components on a printed circuit board (PCB), a workstation, a server, a computing cluster, a blade server, a digital signal processor (DSP), or any other data processing system or computing device. Due to the ever-changing nature of computing devices and networks, the description of the controller 500 depicted in FIG. 5 is intended only as a specific example for purposes of illustrating some embodiments. Many other configurations of the controller 500 are possible having more or fewer components than the controller depicted in FIG. 5.

While the disclosed embodiments have been illustrated and described in considerable detail, it is not the intention to restrict or in any way limit the scope of the appended claims to such detail. It is, of course, not possible to describe every conceivable combination of components or methodologies for purposes of describing the various aspects of the subject matter. Therefore, the disclosure is not limited to the specific details or illustrative examples shown and described. Thus, this disclosure is intended to embrace alterations, modifications, and variations that fall within the scope of the claims, which satisfy the statutory subject matter requirements of 35 U.S.C. §101. The above description of specific embodiments has been given by way of example. From the disclosure given, those skilled in the art will not only understand the general inventive concepts and attendant advantages, but will also find apparent various changes and modifications to the structures and methods disclosed. It is sought, therefore, to cover all such changes and modifications as fall within the spirit and scope of the general inventive concepts, as defined by the appended claims, and equivalents thereof.

### REFERENCE NUMBERS

| | | | |
|---|---|---|---|
| 100 | welding machine | 350 | block |
| 110 | shielded metal arc welding tool | 360 | block |
| 120 | welding output stud | 500 | controller |
| 130 | gas tungsten arc welding tool | 512 | bus subsystem |
| 140 | welding output stud | 514 | processor |
| 150 | workpiece | 516 | network interface subsystem |
| 160 | work stud | 520 | user interface output device |
| 210 | contactor controller | 522 | user interface input device |
| 220 | contactor circuit | 524 | storage subsystem |
| 221 | electrical contactor | 526 | file storage subsystem |
| 222 | electrical contactor | 528 | memory subsystem |
| 223 | electrical contactor | 530 | main random accress memory |
| 224 | electrical contactor | 532 | read only memory |
| 230 | touch sense circuitry | | |
| 232 | sense circuit | SMAW | shielded metal arc welding |
| 234 | sense circuit | | |
| 300 | method | GTAW | gas tungsten arc welding |
| 310 | block | RAM | random access memory |
| 320 | block | ROM | read only memory |
| 330 | block | PCB | printed circuit board |
| 340 | block | DSP | digital signal processor |

## Claims

1. A welding machine (100), the welding machine comprising:
a plurality of electrically isolated welding output studs (120);
a work stud (160);
a contactor circuit (220);
touch sense circuitry (230); and
a contactor controller (210, 500),
wherein the contactor controller (500) is configured to:
determine that electrical contact has occurred between a first welding output stud of the plurality of electrically isolated welding output studs (120) and the work stud (160) via the touch sense circuitry (230),
deactivate welding output power to other welding output studs of the plurality of electrically isolated welding output studs (120) via the contactor circuit (220) based on determining that the electrical contact has occurred, and
activate welding output power to the first welding output stud via the contactor circuit (220) after deactivating the other welding output studs based on determining that the electrical contact has occurred.

2. The welding machine (100) of claim 1, wherein the contactor circuit (220) includes a plurality of electrical contactors (221, 222, 223, 224), and/or wherein the contactor circuit (220) includes a plurality of solid state devices.

3. The welding machine (100) of claim 1 or 2, wherein the touch sense circuitry (230) is part of the contactor controller (210, 500), or
wherein the touch sense circuitry (230) is external to the contactor controller (210, 500) and operatively interfaces to the contactor controller (210, 500).

4. The welding machine (100) of any of the claims 1 to 3, further comprising a shielded metal arc welding (SMAW) tool configured to operatively connect to a SMAW welding output stud of the plurality of electrically isolated welding output studs (120).

5. The welding machine (100) of any of the claims 1 to 4, further comprising a gas tungsten arc welding (GTAW) tool configured to operatively connect to a GTAW welding output stud of the plurality of electrically isolated welding output studs (120).

6. The welding machine (100) of any of the claims 1 to 5, further comprising a gas metal arc welding (GMAW) tool configured to operatively connect to a GMAW welding output stud of the plurality of electrically isolated welding output studs (120) via a wire feeder.

7. The welding machine (100) of any of the claims 1 to 6, wherein the contactor controller (210, 500) is configured to provide coil drive signals to control electrical contactors of the contactor circuit (220), and/or
wherein the contactor controller (210, 500) is configured to provide input activation signals to control solid state devices of the contactor circuit (220).

8. The welding machine (100) of any of the claims 1 to 7, wherein the touch sense circuitry (230) is configured to provide a voltage signal to the work stud.

9. The welding machine (100) of any of the claims 1 to 8, further comprising sense signal circuit paths between the welding output studs (120) and the touch sense circuitry (230).

10. The welding machine (100) of any of the claims 1 to 9, wherein the touch sense circuitry (230) includes voltage sense circuits (232, 234), and/or wherein the touch sense circuitry includes current sense circuits (232, 234).

11. A method of switching between welding output studs of a welding machine, the method comprising:
determining a first electrical contact between a first welding output stud of a welding machine and a work stud of the welding machine via a first touch sense circuit of the welding machine;
in response to determining the first electrical contact:
deactivating a second welding output power to a second welding output stud of the welding machine via a controller of the welding machine controlling a contactor circuit of the welding machine; and
activating a first welding output power to the first welding output stud via the controller again controlling the contactor circuit after deactivating the second welding output power to the second welding output stud.

12. The method of claim 11, further comprising:
determining a second electrical contact between the second welding output stud and the work stud via a second touch sense circuit of the welding machine;
in response to determining the second electrical contact:
deactivating the first welding output power to the first welding output stud via the controller again controlling the contactor circuit; and
activating the second welding output power to the second welding output stud via the controller again controlling the contactor circuit after deactivating the first welding output power to the first welding output stud.

13. The method of claim 11 or 12, further comprising the controller generating coil drive signals to control electrical contactors of the contactor circuit, and/or
further comprising the controller generating activation input signals to control solid state devices of the contactor circuit.

14. The method of any of the claims 11 to 13, further comprising the first touch sense circuit sensing a voltage or a current when the first electrical contact occurs between the first welding output stud and the work stud.

15. The method of any of the claims 11 to 14, further comprising the second touch sense circuit sensing a voltage or a current when the second electrical contact occurs between the second welding output stud and the work stud.
